**Europäisches Patentamt**

**European Patent Office**

**Office européen des brevets**

(19)

(11) Veröffentlichungsnummer: **0 391 105**
**A2**

## (12) EUROPÄISCHE PATENTANMELDUNG

(21) Anmeldenummer: **90104949.4**

(22) Anmeldetag: **16.03.90**

(51) Int. Cl.⁵: **H05K 7/10**

(30) Priorität: **01.04.89 DE 3910518**
**01.02.90 DE 4002901**

(43) Veröffentlichungstag der Anmeldung:
**10.10.90 Patentblatt 90/41**

(84) Benannte Vertragsstaaten:
**AT BE CH DE ES FR GB GR IT LI LU NL SE**

(71) Anmelder: **Haller, Manfred**
**Hugo-Junker-Strasse 13**
**D-7560 Gaggenau(DE)**

Anmelder: **Hagen, Wolfgang**
**Schwalbenweg 7**
**D-7570 Baden-Baden 19(DE)**

(72) Erfinder: **Haller, Manfred**
**Hugo-Junker-Strasse 13**
**D-7560 Gaggenau(DE)**
Erfinder: **Hagen, Wolfgang**
**Schwalbenweg 7**
**D-7570 Baden-Baden 19(DE)**
Erfinder: **Dirks, Christian, Prof. Dipl.-Ing.**
**Richard-Strauss-Weg 2**
**D-7710 Donaueschingen(DE)**

(74) Vertreter: **Zipse & Habersack**
**Lessingstrasse 12**
**D-7570 Baden-Baden(DE)**

(54) **Schaltungsplatine für die optimale Entkopplung von Schaltungen mit digitalen IC's.**

(57) Die Erfindung betrifft eine Schaltungsplatine für die optimale Entkopplung von Schaltungen mit digitalen IC's. Die Platine ist gekennzeichnet durch eine mit einem SMD-Kondensator (7) und zwei damit verbundenen und zu den zu entkoppelnden Punkten führenden Leiterbahnen (3, 4) versehene Platine (1), die mit allen vorhandenen Präzisionskontaktanschlüssen bestückbar ist. Weiterhin ist die Platine der Form des IC's oder des IC-Sockels angepaßt und weist jeweils eine der Anzahl der Kontaktstifte des IC's oder der Kontaktanschlüsse des IC-Sockels entsprechende Anzahl von Bohrungen (2) auf, wobei die zum SMD-Kondensator (7) führenden Leiterbahnen verhältnismäßig breit ausgebildet sind und zu den Anschlüssen der zu entkoppelnden Punkte führen.

Fig.1

EP 0 391 105 A2

Die Erfindung betrifft eine Schaltungsplatine für die Entkopplung von Schaltungen mit digitalen IC's.

Bei der Entkopplung von Schaltungen mit digitalen IC's sind sogenannte "Entkopplungs- oder Abblockkondensatoren" vor jedem IC-Baustein anzuordnen, wobei eine niedrige Induktivität und eine Entkopplung erforderlich ist, um damit Spannungseinbrüche beim Schalten von IC's zu verhindern.

Die zunehmende Geschwindigkeit von IC's stellt höhere Ansprüche an eine wirkungsvolle Filterung und Entkopp lung. Die höheren Einschaltströme und schnelleren Anstiegszeiten der integrierten Schaltungen erzeugen höhere Spannungsspitzen. Die hohen Spannungsspitzen können die ordnungsgemäße Funktion der Systeme wesentlich beeinflussen und müssen deshalb zuverlässig unterdrückt werden. Eine wirkungsvolle Entkopplung, hauptsächlich bei höheren Frequenzen, kann nur durch eine verringerte Zuleitungsinduktivität erzeugt werden. Mit üblichen Entkopplungs- oder Abblockkondensatoren kann die Induktivität nur geringfügig durch sorgfältiges Layout der gedruckten Schaltungen verringert werden. Der Störpegel der herkömmlich auf den Leiterplatten eingesetzten Entkopplungskondensatoren liegt bei ca. 310 mVss.

Der vorliegenden Erfindung liegt nun die Aufgabe zugrunde, eine zusätzliche Schaltungsplatine für die optimale Entkopplung von Schaltungen mit digitalen IC's zu schaffen, welche mit Sicherheit Spannungseinbrüche verhindert und eine optimale Entkopplung gewährt und damit für eine extrem niedrige Induktivität und Anpassung an alle vorhandenen Präzisionskontaktanschlüsse sorgt.

Zur Lösung der gestellten Aufgabe wird eine Schaltungsplatine der eingangs genannten Art vorgeschlagen, welche gekennzeichnet ist durch eine mit einem SMD-Kondensator und zwei damit verbundenen und zu den zu entkoppelnden Kontakten führenden Leiterbahnen versehene Platine, die mit allen vorhandenen Präzisionskontaktanschlüssen bestückbar ist.

Gemäß einer besonderen Ausführungsform ist die Schaltungsplatine gemäß der Erfindung der Form des IC's oder des IC-Sockels angepaßt und weist zwei der Anzahl der Kontaktstifte des IC's oder des Sockels entsprechende Anzahl von Bohrungen auf, wobei die zu dem SMD-Kondensator führenden Leiterbahnen verhältnismäßig breit ausgeführt sind und zu den Anschlüssen der zu entkoppelnden Punkte führen.

Gemäß einer weiteren Ausführungsform sind in die Platine und diese durchquerend Kontaktanschlüsse eingesetzt, die dem entsprechenden IC als IC-Fassung angepaßt sind, wobei die zu entkoppelnden Kontaktanschlüsse mit den Leiterbahnen für den SMD-Kondensator verbunden sind.

Gemäß einer besonderen Ausführungsform können die verhältnismäßig breiten Leiterbahnen für den SMD-Kondensator mit den diagonal liegenden Anschlußstiften der Spannungsversorgung und der Masse des IC's verbunden sein.

Mit der Schaltungsplatine gemäß der Erfindung werden mehrere Vorteile erreicht. So kann die Schaltungsplatine als Träger für IC-Bausteine dienen. Sie kann auch als weiterer Baustein zum einfachen Nachrüsten von IC-Fassungen oder IC-Bausteinen oder zum Nachrüsten von bereits auf der Leiterplatte montierten oder eingesteckten IC-Bausteinen, IC-Fassungen oder Wrap-Kontaktanschlüssen eingesetzt werden.

Die Schaltungsplatine kann zusätzlich mit einer sogenannten "Wrap-ID-Pinkennung" (Adreßschild) markiert sein und kann gleichzeitig als ein praktisches und zeitsparendes Hilfsmittel in der Wire-Wrap-Verdrahtung eingesetzt werden.

Schließlich ermöglicht der Einsatz der Kondensator-IC-Fassung ein direktes Stecken auf dieselben Bohrungen des Speicher-IC's, wodurch das Layout bei der Herstellung von Platinen wesentlich vereinfacht und die Kosten für die Leiterplattenproduktion gesenkt werden können.

Nachdem die Kondensatorplatine oder die Kondensator-IC-Fassung in die gleichen Bohrungen wie das IC eingefügt wird, braucht die Plazierung beim Leiterplatten-Layout nicht berücksichtigt zu werden. Das bedeutet, daß die Schaltungsplatine gemäß der Erfindung auf jede bereits existierende Leiterplatte ohne Layoutänderung eingefügt werden kann und zu Gunsten erhöhter Packungsdichte bis zu 30 % keine zusätzliche Leiterplattenfläche beansprucht wird.

Die Schaltungsplatine kann durch weitere Ausgestaltung noch dadurch wesentlich verbessert werden, daß eine besonders breitbandige Entkopplung bis zu einer Frequenz von 300 MHz und mehr durchgeführt werden kann. Hierzu wird eine Schaltungsplatine vorgeschlagen, welche dadurch gekennzeichnet ist, daß bei der beidseitig mit Metall, insbesondere Kupfer, kaschierten Platine die mit dem Anschluß für die Versorgungsspannung verbundene, über die freie Breite der Platine bis in die Nähe der Bohrungen reichende Leiterbahn durch Materialaussparung in zwei miteinander verbundene Leiterbahnen aufgeteilt ist, deren Enden von einer über die Breite der Platine reichenden, mit dem Masseanschluß verbundenen Leiterbahn durch Materialaussparung getrennt sind, und daß jedes Ende der zwei aufgeteilten Leiterbahnen über mindestens je einen Entkopplungskondensator mit der an Masse liegenden Leiterbahn verbunden ist, und daß die Kondensatoren über mindestens einen Widerstand miteinander verbunden sind.

Gemäß einer weiteren Ausführungsform der Schaltungsplatine ist die rückseitige, über die Breite der Platine bis in die Nähe der Bohrungen reichende Leiterbahn ebenfalls mit Masse verbunden.

Mit der Platine gemäß der Erfindung wird der wesentliche Vorteil erreicht, daß eine besonders breitbandige Entkopplung des IC's in der Schaltung bis zu einer Frequenz von 300 MHz und darüber erzielt wird.

Gemäß einer Weiterbildung der Schaltungsplatine beträgt das Verhältnis der Breiten der beiden aufgeteilten, mit der Versorgungsspannung verbundenen Leiterbahnen ca. 1:1 bis 1:3.

Die Breite der Leiterbahn, die mit Masse verbunden ist und an der die Kondensatoren liegen, entspricht etwa dem Abstand von zwei Bohrungen auf der Leiterbahn. Selbstverständlich kann dieser Abstand größer oder kleiner gewählt werden, wenn dies zu einer noch besseren Entkopplung beiträgt.

Gemäß einer weiteren Ausführungsform der Platine beträgt die Kapazität des zur breiteren Leiterbahn führenden Kondensators ca. 1 nF, und die Kapazität des zu der schmaleren Leiterbahn führenden Kondensators beträgt 0,1 uF, wobei der die beiden Kondensatoren verbindende Widerstand ca. 2,2 Ohm beträgt. Sämtliche Bauteile können vorzugsweise in sogenannter "SMD-Technik" ausgeführt sein.

Gemäß einer weiteren Ausführungsform beträgt die Platinendicke ca. 0,5 mm.

Da die Platine im allgemeinen in Verbindung mit dem IC-Sockel gebracht wird, kann sie durch Einpreßtechnik mit dem Sockel verbunden werden.

Anhand der Zeichnungen soll am Beispiel von bevorzugten Ausführungsformen die Schaltungsplatine gemäß der Erfindung näher erläutert werden.

In den Zeichnungen zeigt

Fig. 1 eine Ausführungsform der Schaltungsplatine gemäß der Erfindung in perspektivischer Ansicht.

Fig. 2 zeigt eine weitere Ausführungsform der Schaltungsplatine gemäß der Erfindung als IC-Fassung.

Fig. 3 zeigt eine erste Anwendungsmöglichkeit der Schaltungsplatine in Verbindung mit einem IC und einer Leiterplatine in auseinandergezogener, perspektivischer Ansicht.

Fig. 4 zeigt eine ähnliche Ansicht wie Fig. 3 mit einer Schaltungsplatine gemäß Fig. 1.

Fig. 5 zeigt eine ähnliche Anordnung wie Fig. 3 mit einer anderen Ausführungsform der Schaltungsplatine gemäß der Erfindung.

Fig. 6 zeigt schließlich noch eine weitere Anwendungsmöglichkeit der Schaltungsplatine gemäß der Erfindung.

Fig. 7 zeigt eine prinzipielle Ansicht der Bestückungsseite der Platine gemäß der Erfindung mit einer Verbesserung.

Fig. 8 zeigt eine prinzipielle Ansicht der Rückseite der Platine gemäß Fig. 7.

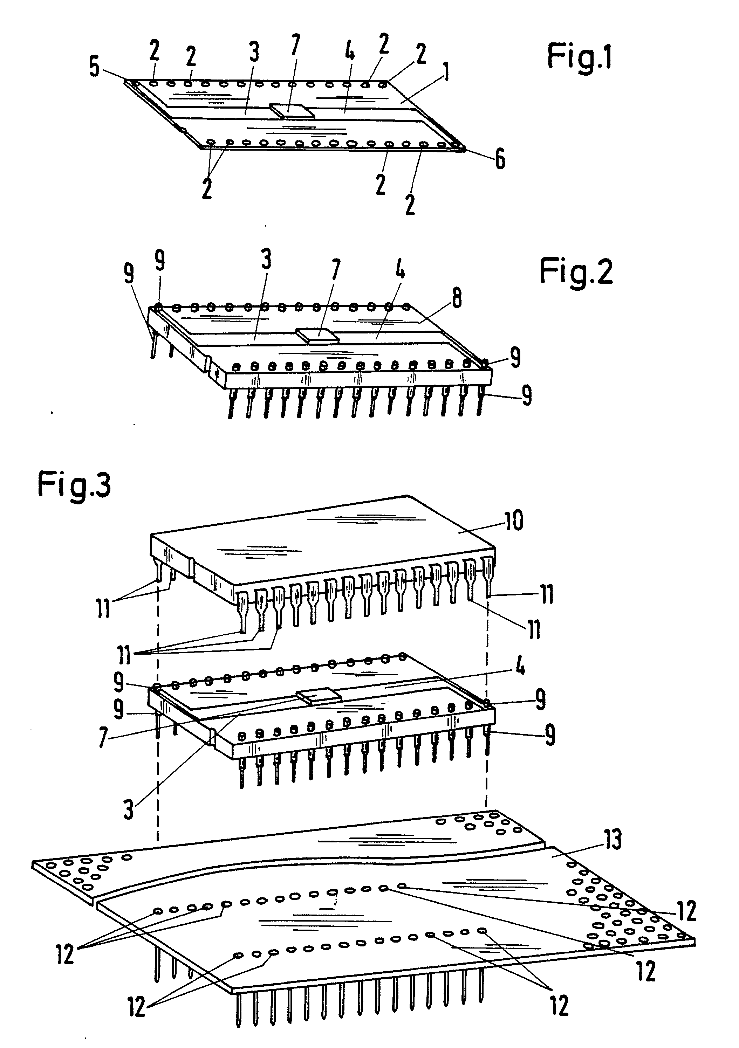

Wie sich aus Fig. 1 ergibt, besteht die Schaltungsplatine gemäß der Erfindung aus einem rechteckförmigen Platinenkörper 1, beispielsweise aus Epoxidhard oder einem anderen geeigneten Werkstoff. In diesen rechteckförmigen Platinenkörper sind mehrere, dem Abstand und der Anordnung der Stiftkontakte eines IC's entsprechende Bohrungen 2 angebracht. Auf der Platine sind zwei verhältnismäßig breite Leiterbahnen 3, 4 in üblicher Anordnung aufgebracht, die zu den diagonal vorhandenen Bohrungen 5, 6 führen und dort später mit den Anschlüssen des IC's verbunden werden. Die beiden verhältnismäßig breiten Leiterbahnen 3, 4 führen zu einem SMD-Entkopplungskondensator 7. Die Form und die geometrische Ausbildung und Anordnung der Leiterbahnen 3 und 4 kann beliebig sein.

In Fig. 2 ist eine andere Ausführungsmöglichkeit der Schaltungsplatine gemäß der Erfindung dargestellt. In diesem Fall sind in einer etwas dikkeren Platte 8 entsprechend den Kontaktstiften des einzusetzenden IC's die Platine durchquerende Kontaktanschlüsse 9 als IC-Fassung eingesetzt, wobei die beiden Leiterbahnen 3 und 4, die mit dem SMD-Kondensator 7 verbunden sind, zu den beiden äußeren, diametral einander gegenüberliegenden Kontaktanschlüssen führen.

In Fig. 3 ist eine Möglichkeit der Anwendung der in Fig. 2 dargestellten Schaltungsplatine gemäß der Erfindung gezeigt. Das IC 10 ist mit seinen Kontaktstiften 11 in die Kontaktanschlüsse 9 der Schaltplatine der als IC-Fassung dienenden, etwas dickeren Platte 8 eingesteckt. Die gesamte Anordnung wird dann in die durchkontaktierten Bohrungen 12 der Leiterplatte 13 eingesteckt und in üblicher und bekannter Weise mit dieser durch Löten verbunden.

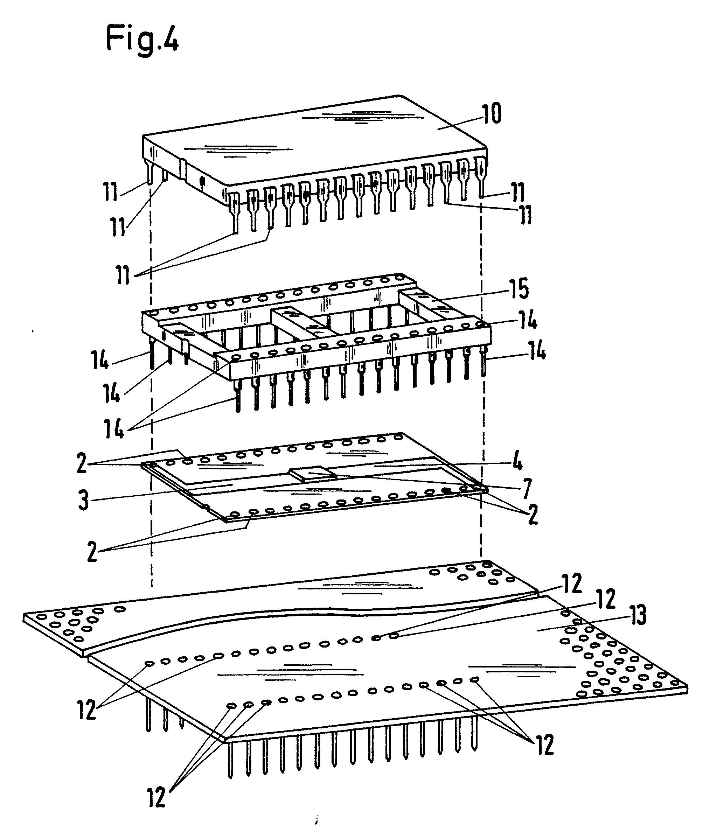

In Fig. 4 ist eine Möglichkeit der Verbindung des IC's 10 mit den Kontaktstiften 11 gezeigt, wobei diese in Kontaktanschlüsse 14 einer IC-Fassung 15 eingesteckt sind. Auf die Kontaktanschlüsse 14 der IC-Fassung 15 wird von unten eine Schaltplatine, wie sie in Fig. 1 dargestellt ist, derart aufgesteckt, daß die Kontaktanschlüsse 14 mit ihren unteren Stiften die Bohrungen 2 der Schaltplatine 1 durchdringen. Die Verbindung der beiden Leiterbahnen 3 und 4 erfolgt über die diametral gegenüberliegenden Anschlüsse 14, an welche die Versorgungsspannung und die Masse anliegen. Das Ganze wird dann wiederum in die Bohrungen 12 der Leiterplatte 13 eingesteckt und in bekannter Weise, beispielsweise durch Löten, mit dieser verbunden.

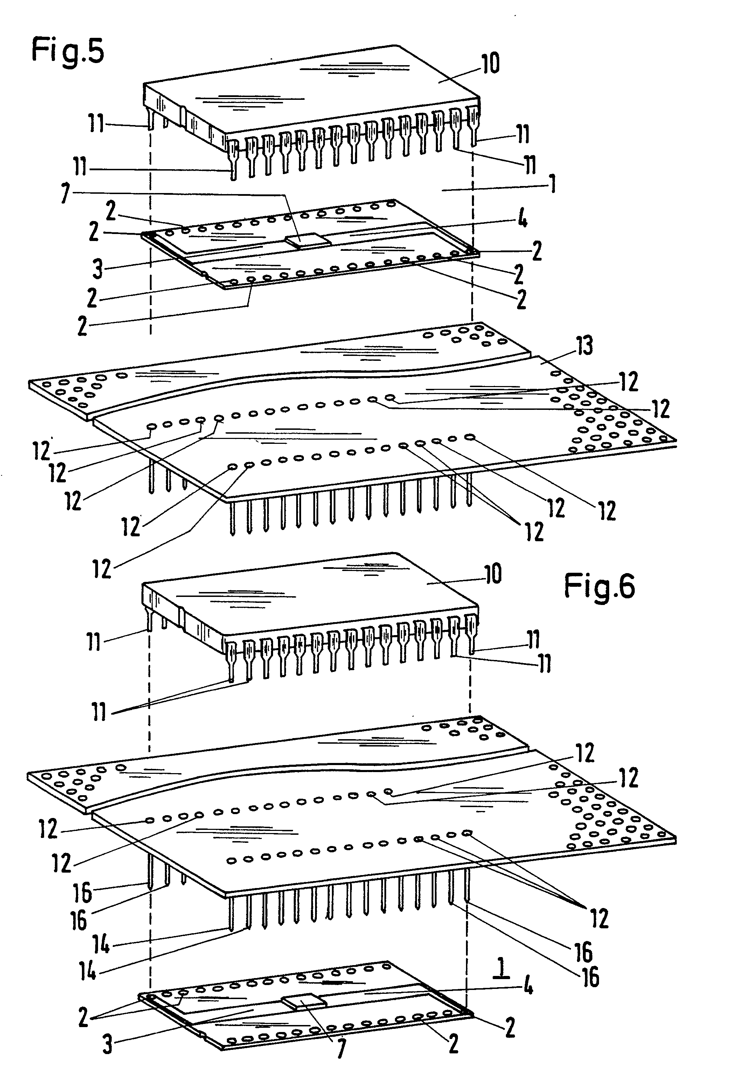

Eine vereinfachte Ausführungsform ist in Fig. 5 dargestellt. Hier ist das IC 10 mit seinen Anschlußstiften 11 unmittelbar auf die Schaltplatine 1 gesteckt, wobei die Anschlußstifte 11 durch die Bohrungen 2 der Platine verlaufen und die diametral verlaufenden Stifte 11 über die Leiterbahnen 3, 4 über den Entkopplungskondensator 7 verbunden sind. Das IC wird dann unmittelbar in die Bohrungen 12 der Leiterplatte 13 gesteckt und mit dieser beispielsweise verlötet.

Eine umgekehrte Möglichkeit ist in Fig. 6 dargestellt. Dort ist das IC 10 mit seinen Anschlüssen 11 direkt in die Bohrungen 12 der Leiterplatte 13 gesteckt und wird mit dieser verlötet. Von unten ist auf durchgehende Stifte 16 die Schaltplatine 1 mit ihren Bohrungen 2 aufgesetzt und wird an den diametral gegenüberliegenden Anschlußstiften 14 durch Löten verbunden.

Die Schaltplatine gemäß der Erfindung kann mit 14, 16, 18, 20, 22, 24, 28, 30, 32, 36, 40, 42, 48 und 64-poligen Anschlüssen für Standard DIP-IC's mit diagonal angeordneter Spannungsversorgung und Masseanschlüssen vorgesehen werden. Es sind selbstverständlich auch Ausführungen mit anderen Stromversorgungs- und Masseanschlüssen möglich. Das Basismaterial für die Schaltplatine gemäß der Erfindung kann aus Epoxidharz mit 0,5 bis 1,5 mm Dicke bestehen.

Die Platine gemäß der Erfindung kann auch für andere IC-Bausteine, Pin-Grid-Array-Fassungen sowie PLCC- und LCC-Fassungen eingesetzt werden.

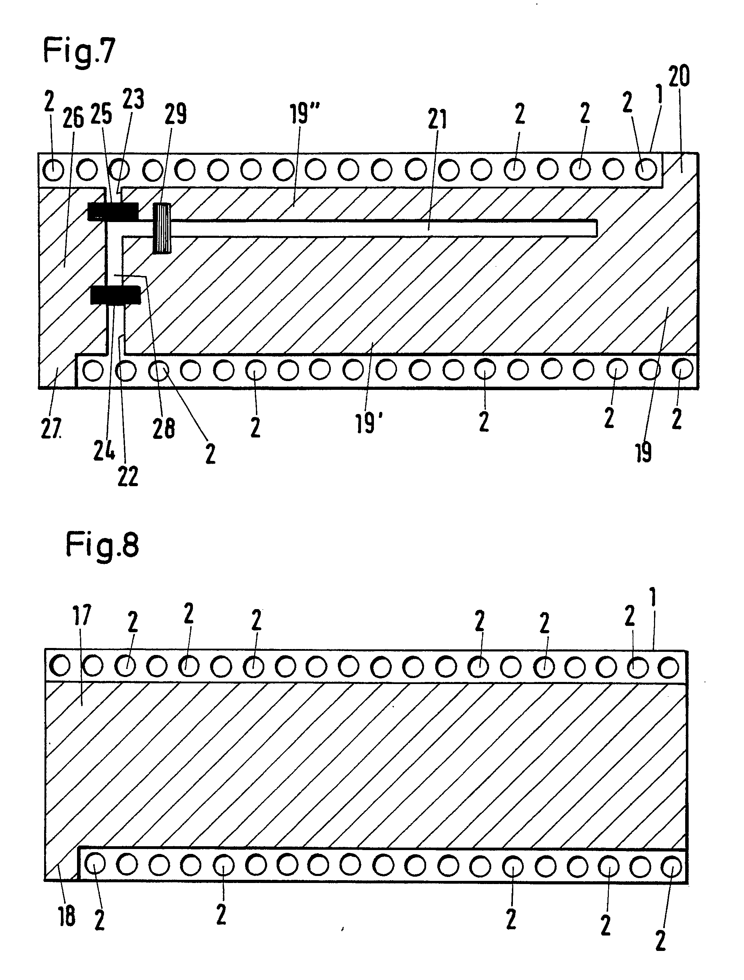

Wie sich aus den Figuren 7 und 8 ergibt, besteht die Schaltungsplatine gemäß der Erfindung aus einem rechteckförmigen Platinenkörper 1, beispielsweise aus Epoxidharz oder einem anderen geeigneten Werkstoff, der doppelseitig kaschiert ist. In diesem Platinenkörper 1 sind mehrere, dem Abstand und der Anordnung der Stiftkontakte des IC's entsprechende Bohrungen 2 angebracht. Auf der Rückseite ist die über die Breite der Platine bis in die Nähe der Bohrungen 2 reichende Leiterbahn 17 als Metallschicht kaschiert aufgebracht, die mit dem Masseanschluß 18 verbunden ist (Fig. 8). Die Bestückungsseite (Fig. 7) der Platine 1 weist ebenfalls eine über die freie Breite der Platine bis in die Nähe der Bohrungen 2 reichende Leiterbahn 19 auf, die mit dem Versorgungsspannungsanschluß 20 verbunden ist. Die Leiterbahn 19 ist durch eine Materialaussparung 21 in zwei miteinander verbundene Leiterbahnen 19', 19" aufgeteilt.

Die Enden 22, 23 der beiden Leiterbahnen sind über je einen Kondensator 24 von 1nF und 11 von 0,1uF mit einer weiteren Leiterbahn 26 verbunden, die an dem Masseanschluß 27 liegt und durch eine weitere Materialaussparung 28 von den beiden Leiterbahnen 19', 19"getrennt ist.

Die beiden Kondensatoren 24,25 sind im Bereich der Enden der Leiterbahnen 19', 19" mit einem Widerstand 29 von ca. 2,2 Ohm verbunden. Sämtliche Bauteile können in SMD-Technik ausgeführt sein.

Die so aufgebaute Platine gemäß der Erfindung kann mit dem IC-Sockel durch Einpreßtechnik verbunden werden.

## Ansprüche

1. Schaltungsplatine für die optimale Entkopplung von Schaltungen mit digitalen IC's, **gekennzeichnet durch** eine mit einem SMD-Kondensator (7) und zwei damit verbundenen und zu den zu entkoppelnden Punkten führenden Leiterbahnen (3, 4) versehene Platine (1), die mit allen vorhandenen Präzisionskontaktanschlüssen bestückbar ist.

2. Schaltungsplatine nach Anspruch 1, **dadurch gekennzeichnet,** daß die Platine der Form des IC's oder des IC-Sockels angepaßt ist und jeweils eine der Anzahl der Kontaktstifte (11) des IC's(10) oder der Kontaktanschlüsse (14) des IC-Sockels (15) entsprechende Anzahl von Bohrungen (2) aufweist, wobei die zum SMD-Kondensator (7) führenden Leiterbahnen verhältnismäßig breit ausgebildet sind und zu den Anschlüssen der zu entkoppelnden Punkte führen.

3. Schaltungsplatine nach Anspruch 1, **dadurch gekennzeichnet,** daß die Platine (8) dem IC (10) angepaßt ist und mit die Platine durchquerenden Kontaktanschlüssen (9) als IC-Fassung versehen ist, wobei die zu entkoppelnden Kontaktanschlüsse (9) mit den Leiterbahnen (3, 4), die zum SMD-Kondensator (7) führen, verbunden sind.

4. Schaltungsplatine nach Anspruch 1, 2 oder 3, **dadurch gekennzeichnet,** daß die verhältnismäßig breiten Leiterbahnen (3, 4) für den SMD-Kondensator (7) mit den diametral gegenüberliegenden Anschlüssen für die Spannungsversorgung und die Masse verbunden sind.

5. Schaltungsplatine für die optimale Entkopplung von Schaltungen mit digitalen IC's gemäß Anspruch 2 und 3, **dadurch gekennzeichnet,** daß bei der beidseitig mit Metall, insbesondere Kupfer, kaschierten Platine (1) die mit dem Anschluß für die Versorgungsspannung verbundene, über die freie Breite der Platine (1) bis in die Nähe der Bohrungen (2) reichende Leiterbahn durch Materialaussparung (21) in zwei miteinander verbundene Leiterbahnen (19', 19") aufgeteilt ist, deren Enden (22,23) von einer über die Breite der Platine (1) reichenden, mit dem Masseanschluß verbundenen Leiterbahn (26) durch Materialaussparung (28) getrennt sind, und daß jedes Ende "22, 23) der zwei aufgeteilten Leiterbahnen (19', 19") über mindestens je einen Entkopplungskondensator (24, 25) mit der an Masse liegenden Leiterbahn (26) verbunden ist, und daß die Kondensatoren (25,26 ) über mindestens einen Widerstand (29) miteinander verbunden sind.

6. Schaltungsplatine nach Anspruch 5, **dadurch gekennzeichnet,** daß die rückseitige, über die Breite der Platine (1) bis in die Nähe der Bohrungen (2) reichende Leiterbahn (17) mit Masse verbunden ist.

7. Schaltungsplatine nach Anspruch 5 und 6, **dadurch gekennzeichnet,** daß das Verhältnis der Breiten der aufgeteilten Leiterbahnen (19′, 19″) ca. 1:1 bis 1:3 beträgt.

8. Schaltungsplatine nach einem oder mehreren der vorhergehenden Ansprüche, **dadurch gekennzeichnet,** daß die Breite der mit Masse verbundenen Leiterbahn (26) ca. dem Abstand von zwei Bohrungen (2) entspricht.

9. Schaltungsplatine nach einem oder mehreren der vorhergehenden Ansprüche, **dadurch gekennzeichnet,** daß der zu der breiteren Leiterbahn (19′) führende Kondensator ca. 1nF und der zu der schmaleren Leiterbahn (19″) führende Kondensator 0,1 uF und der die Kondensatoren verbindende Widerstand (29) ca. 2,2 Ohm beträgt, und daß diese Bauteile in SMD-Technik ausgeführt sind.

10. Schaltungsplatine nach einem oder mehreren der vorhergehenden Ansprüche, **dadurch gekennzeichnet,** daß die Platine (1) eine Stärke von 0,5 mm aufweist.

11. Schaltungsplatine nach einem oder mehreren der vorhergehenden Ansprüche, **dadurch gekennzeichnet,** daß die Platine (1) mit dem IC-Sockel durch Einpressen verbunden ist.

Fig.1

Fig.2

Fig.3

# Fig.4

EP 0 391 105 A2

Fig.5

Fig.6

Fig.7

Fig.8